Europäisches Patentamt

European Patent Office

Office européen des brevets

(11) Publication number: **0 206 084 B1**

# EUROPEAN PATENT SPECIFICATION

(45) Date of publication of patent specification: **15.07.92**   (51) Int. Cl.⁵: **G01R 19/155**, G01R 19/165, H03K 17/22

(21) Application number: **86107857.4**

(22) Date of filing: **09.06.86**

(54) CMOS power-on detection circuit.

(30) Priority: **18.06.85 GB 8515434**

(43) Date of publication of application:
**30.12.86 Bulletin 86/52**

(45) Publication of the grant of the patent:
**15.07.92 Bulletin 92/29**

(84) Designated Contracting States:
**DE FR IT NL**

(56) References cited:
**US-A- 4 103 190**
**US-A- 4 140 930**
**US-A- 4 300 065**

(73) Proprietor: **MOTOROLA, INC.**
**1303 East Algonquin Road**
**Schaumburg, IL 60196(US)**

(72) Inventor: **Rusznyak, Andreas**
**3 Avenue Des Cavaliers**
**Chene-Bougeries CH1224(CH)**

(74) Representative: **Ibbotson, Harold et al**
**Motorola Ltd Patent and Licensing Oper-**
**ations - Europe Jays Close Viables Industrial**
**Estate**
**Basingstoke Hampshire RG22 4PD(GB)**

**Description**

This invention relates to a CMOS power-on detection circuit for indicating when a rising supply potential reaches either a predetermined or a maximum value.

In copending United Kingdom Patent Application No. 8406687 there is described a CMOS power-on detection circuit which provides an output indication when the largest threshold voltage of the transistors in the circuit is exceeded.

The circuit of this copending application overcomes a problem of other known circuits in which detection is only made when the supply potential exceeds the sum of two threshold voltages and may provide a detection circuit in which no current is consumed by the circuit after detection.

Power-on detection on exceeding the largest threshold voltage can however be disadvantageous in certain circumstances. For example some logic circuits do not operate correctly at supply potentials which just exceed the threshold voltage. In such cases the power-on detection circuit of the above mentioned copending application would provide a power-on indication at a point in time in the rise of the supply potential at which the circuit is not fully operative. A circuit in accordance with the prior art part of claim 1 is disclosed in US-A-4,300,065.

This invention seeks to provide an improved power-on detection circuit.

According to this invention there is provided a CMOS power-on detection circuit comprising first and second supply lines; first and second complementary MOS transistors connected in series between the first and second supply lines with their drain electrodes connected together to form a first node , the gate electrode of the first transistor being connected so that the first transistor has an output conductance which increases as the supply potential rises; and characterised by capactive means in which a charging current is generated in response to a rising supply potential; means, for driving the gate electrode of the second transistor to provide a second output conductance dependent upon the charging current, an indication of the supply potential having attained a predetermined or maximum value being provided by a predetermined potential change at the said node in dependance upon the relative values of the first and second output conductances.

The charging current in the capacitive means may be generated through first diode means connected in series with the capacitive means between the first and second supply lines and forming a second node therebetween, the first diode means conveniently being formed by a third MOS transistor having its gate electrode connected to the second node.

The means for driving the second transistor may comprise current mirror means whereby current passed by the second transistor is a predetermined multiple of the charging current in the capacitive means.

In an embodiment of the invention the current mirror means includes a fourth MOS transistor and second diode means coupled in series between the first and second supply lines and having a third node therebetween, the third node being connected to the gate electrode of the second transistor, the gate electrode of the fourth transistor being connected to the second node and preferably the third and fourth transistors being of the same conductivity type.

The current mirror means preferably comprises a plurality of current mirrors.

The second diode means may be formed by a fifth MOS transistor having its gate electrode connected to the third node.

Output means may be coupled to the said node and conveniently the output means comprises inverting means.

Typically the inverting means are formed by two CMOS inverters.

Preferably additional means is provided responsive to the predetermined potential change at the said node for reducing current consumption by the circuit following said indication.

The additional means may comprise means for terminating current in the current mirror means.

An exemplary embodiment of the invention will now be described with reference to the drawings in which;

Figure 1 shows a preferred embodiment of a power-on detection circuit in accordance with the present invention and;

Figure 2 is a graph illustrating the rise of the supply potential VDD with time for the circuit of Figure 1.

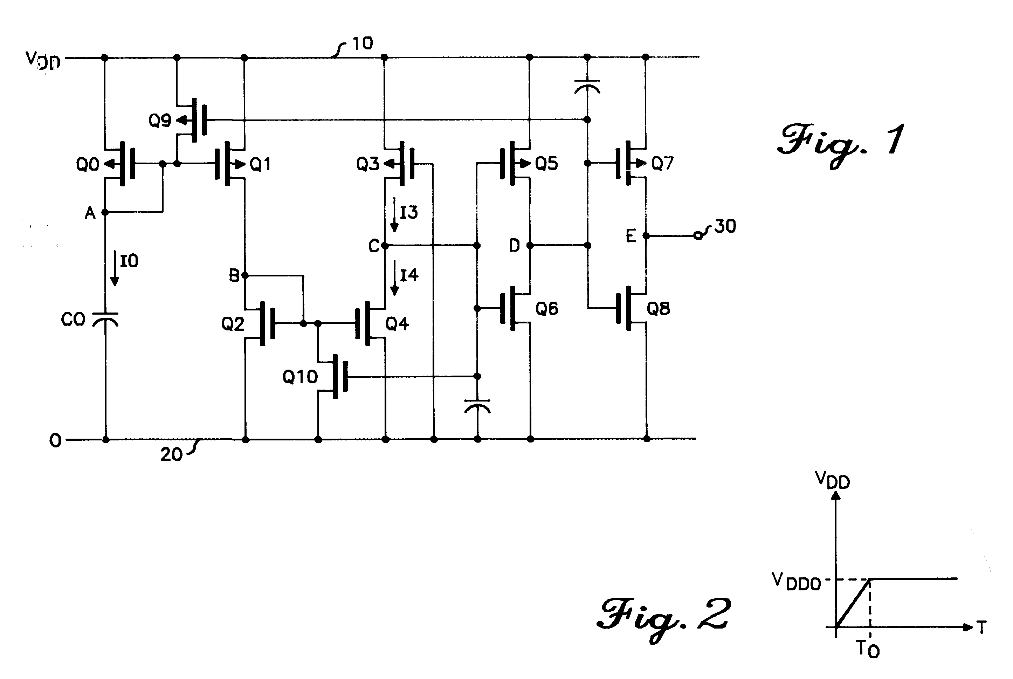

Referring now to Figure 1 the circuit comprises first and second supply lines 10 and 20, the supply line 10 receiving a supply voltage VDD and the supply line 20 being a reference line, the supply voltage VDD being positive referenced to the reference line.

A capacitor C0 has a first terminal connected to the supply line 20 and its second terminal connected at node A to the drain electrode of a P-channel MOS transistor Q0 which has its drain electrode also connected to its gate electrode to form a diode and its source electrode connected to the supply line 10.

A pair of complementary MOS transistors Q1 and Q2 are connected in series between the supply lines 10 and 20 with the source electrodes of the transistors Q1 and Q2 respectively connected to the supply lines 10 and 20 and their drain electrodes coupled together to form a node B. The transistor Q2 which is the N-channel transistor of the pair also has its gate electrode connected to its drain electrode at the node B to form a diode and the gate of the P-channel transistor Q1 is connected to that of the transistor Q0.

A further pair of complementary MOS transistors formed by a P-channel transistor Q3 and an N-channel transistor Q4 are connected in series between the supply lines 10 and 20, the source electrodes of the transistors Q3 and Q4 being connected to the supply lines 10 and 20 respectively and the drain electrodes of the transistors being connected together to form a node C. The gate electrode of the transistor Q4 is connected to that of the transistor Q2 and the gate electrode of the transistor Q3 is connected to the supply line 20.

Referring now to Figures 1 and 2 together, the instantaneous voltage VDD of the supply which is applied to the supply line 10 rises with time T following its application until it reaches a maximum value VDD0 at a time T0. This rising supply potential may be expressed as;

$$VDD = S.T \text{ where } S = VDD0/T0$$

When the threshold voltage VT of the P channel transistor Q0 is exceeded the capacitor C0 will be charged through the diode connected transistor Q0 by a current I0 where;

$$I0 = S.C0$$

By the action of a current mirror circuit formed by two current mirrors and which includes the complementary MOS transistors QI and Q2 the gate electrode of the transistor Q4 will be driven by a voltage derived from the instantaneous voltage on the capacitor C0 and the transistor Q4 is able to pass a saturation current I4 which is a multiple N of the charging current I0 of the capacitor C0.

This saturation current I4 of the transistor Q4 may therefore be expressed as

$$I4 = N.I0$$

where N is a predetermined multiplier.

As long as the current I4 is greater than the current I3 where

$$I3 = K3 (VDD0 - VT)^2$$

K3 being a constant dependent upon the parameters of the transistor Q3, the voltage on the node C between the transistors Q3 and Q4 will be held close to the potential of the supply line 20, i.e. nearly at zero volts.

It is possible that the current I3 will exceed the current I4 at a point in time before that at which the supply potential stabilizes at its maximum value.

In this case the condition I3 exceeds I4 is reached when

$$N.S.C0 = K3(VDD-VT)^2$$

and the potential at the node C will change to VDD when

$$VDD-VT = \sqrt{N \frac{S.C0}{K3}}$$

In this way, the circuit will provide a power-on indication by means of a rapid change of the potential at the node C from zero to VDD when the rising supply potential has reached a predetermined value.

If the supply voltage VDD reaches its maximum value VDD0 before the condition

$$N.S.C0 = K3 (VDD - VT)^2$$

has been reached, the current I0 charging the capacitor C0 will decrease and may be expressed by the equation

$$I0 = \frac{K0}{\left[\frac{K0}{C0}(T-T0) + \sqrt{\frac{K0}{S \cdot C0}}\right]^2}$$

where K0 is a constant defined by the equation

$$I0 = K0(V-VT)^2$$

The current I4 will become lower than the current I3 at a time T given by

$$T-T0 = \frac{C0}{K0}\left[\sqrt{\frac{N \cdot K0}{I3}} - \sqrt{\frac{K0}{S \cdot C0}}\right]$$

At this point the transistor Q3 conducts more strongly than the transistor Q4 and the voltage at the node C will switch to that of the supply potential VDD.

Consequently a change in the potential at the node C from zero volts to VDD provides an indication that the supply voltage has ceased to rise.

As described above the circuit provides a power-on indication by means of a change in the potential at the node C when the rising supply voltage has reached a predetermined value or a short time after the supply potential VDD has reached a maximum value.

In order to provide a suitable output signal from the circuit the node C between the transistors Q3 and Q4 is coupled to an output terminal 30 by two series connected CMOS inverters. The first of the inverters is formed by a P-channel transistor Q5 and an N channel transistor Q6 connected in series between the supply lines 10 and 20 and having their drain electrodes connected together to form a node D. The gate electrodes of the transistors Q5 and Q6 are connected together and to the node C. The second inverter is provided by a P channel transistor Q7 and an N channel transistor Q8 connected between the supply lines 10 and 20, the gate eletrodes of which transistors are connected to the node D and the drain electrodes of which are connected together at a node E and to an output terminal 30. When the voltage at the node C rises to the potential VDD to indicate power-on, the potential at the output terminal 30 will also become VDD.

In order to cut current consumption by the circuit following the provision of a power-on detection signal at the output terminal 30 the node D is connected to the gate electrode of a P-channel MOS transistor Q9 whose source eletrode is connected to the supply line 10 and whose drain electrode is connected to the gate electrode of the transistor 1. Similarly the node C is connected to the gate electrode of a N-channel MOS transistor Q10 whose source electrode is connected to the supply line 20 and whose drain electrode is connected to the gate electrode of the transistor Q4.

When the potential at the node C becomes equal to the supply potential VDD the transistors Q9 and Q10 will be turned on thereby cutting current through the transistors Q1 and Q4 so that the power-on detection circuit ceases to consume current when the power rising is over.

Nevertheless, once a detection is made by the circuit of the rise of the supply potential VDD applied to the supply line 10, the circuit will remain in a switched condition with the output terminal 30 providing an indicating output voltage equal to VDD until such time as the supply potential VDD falls below the threshold voltage VT.

The invention has been described by way of example and modifications may be made without departing from the scope of the invention. For example, although in the described embodiment the transistor Q4 is driven from the charging current developed in the capacitor C0 via two current mirrors, this is not essential and more or fewer mirrors may be employed. If desired no current mirror need be used in which case the transistors Q0 and Q4 would be of the same conductivity type with their gate electrodes connected together.

**Claims**

1. A CMOS power-on detection circuit comprising first and second supply lines (10, 20); first and second complementary MOS transistors (Q3, Q4) connected in series between the first and second supply lines with their drain electrodes connected together to form a first node (C), the gate electrode of the first transistor (Q3) being connected so that the first transistor has an output conductance which increases as the supply potential rises; and characterised by capacive means (C0) in which a charging current (I0) is generated in response to a rising supply potential (VDD); means (Q1, Q2) for driving the gate electrode of the second transistor (Q4) to provide a second output conductance dependent upon the charging current (I0), an indication of the supply potential (VDD) having attained a predetermined or maximum value being provided by a predetermined potential change at the said node in dependance upon the relative values of the first and second output conductances.

2. The circuit of claim 1 wherein the charging current (I0) in the capacitive means (C0) is generated through first diode means (Q0) connected in series with the capacitive means between the first and second (C0) supply lines (10,20) and forming a second node (A) therebetween.

3. The circuit of claim 2 wherein the first diode means (Q0) is formed by a third MOS transistor having its gate electrode connected to the second node.

4. The circuit of any preceding claim wherein the means for driving the gate electrode of the second transistor (Q4) comprises current mirror means (Q1,Q2) whereby current passed by the second transistor is a predetermined multiple of the charging current (I0) in the capacitive means (C0).

5. The circuit of claim 4 wherein the current mirror means includes a further MOS transistor (Q1) and second diode means (Q2) coupled in series between the first and second supply lines (10, 20) and having a third node (B) therebetween, the third node being connected to the gate electrode of the second transistor (Q4), the gate electrode of the further MOS transistor (Q1) being connected to the second node (A).

6. The circuit of claim 5 wherein the first diode means is formed by a MOS transistor (Q0) having its gate electrode connected to the second node and the said MOS and further MOS transistors (Q0,Q1)have the same conductivity type.

7. The circuit of any one of claims 4 to 6 wherein the current mirror means comprises a plurality of current mirrors.

8. The circuit of any preceding claim wherein output means comprising inverting means (Q5 to Q8) is coupled to the said node (C) between said first and second complementary MOS transistors (Q3,Q4).

9. The circuit of claim 8 wherein the inverting means is formed by two CMOS inverters (Q5, Q6 and Q7, Q8).

10. The circuit of any preceding claim wherein additional means (Q9, Q10) is provided responsive to the predetermined potential change at the said node (C) for reducing current consumption by the circuit following said indication.

11. The circuit of claim 10 wherein the additional means (Q9, Q10) comprises means for terminating current in the current mirror means (Q1, Q2).

**Revendications**

1. Un circuit de détection de mise sous tension de type CMOS, comprenant des première et seconde lignes d'alimentation (10, 20); des premier et second transistors MOS complémentaires (Q3, Q4) connectés en série entre les première et seconde lignes d'alimentation, avec leurs électrodes de drain connectées ensemble pour former un premier noeud (C), l'électrode de grille du premier transistor (Q3) étant connectée de façon que le premier transistor ait une conductance de sortie qui augmente lorsque le potentiel d'alimentation s'élève; et caractérisé par des moyens capacitifs (C0) dans lesquels un courant de charge (I0) circule sous l'effet d'un potentiel d'alimentation croissant (VDD); des moyens (Q1, Q2) destinés à attaquer l'électrode de grille du second transistor (Q4) pour produire une seconde conductance de sortie qui dépend du courant de charge (I0), un changement de potentiel prédéterminé sur le noeud précité, sous la dépendance des valeurs relatives des première et seconde conductances de sortie, indiquant que le potentiel d'alimentation (VDD) a atteint une valeur prédéterminée ou maximale.

2. Le circuit de la revendication 1, dans lequel le courant de charge (I0) qui circule dans les moyens capacitifs (C0) circule dans une première structure de diode (Q0) qui est connectèe en série avec les moyens capacitifs (C0), entre les première et seconde lignes d'alimentation (10, 20), et qui forme un second noeud (A) entre eux.

3. Le circuit de la revendication 2, dans lequel la première structure de diode (Q0) est formée par un troisième transistor MOS dont l'électrode de grille est connectée au second noeud.

4. Le circuit de l'une quelconque des revendications précédentes, dans lequel les moyens qui sont destinés à attaquer l'électrode de grille du second transistor Q4 comprennent une structure à miroirs de courant (Q1, Q2), grâce à laquelle le courant que fait circuler le second transistor est un multiple prédéterminé du courant de charge (I0) qui circule dans les moyens capacitifs (C0).

5. Le circuit de la revendication 4, dans lequel la structure à miroirs de courant comprend un transistor MOS supplémentaire (Q1) et une seconde structure de diode (Q2) connectés en série entre les première et seconde lignes d'alimentation (10, 20) et ayant un troisième noeud (B) entre eux, le troisième noeud étant connecté à l'électrode de grille du second transistor (Q4), et l'électrode de grille du transistor MOS supplémentaire (Q1) étant connectée au second noeud (A).

6. Le circuit de la revendication 5, dans lequel la première structure de diode est formée par un transistor MOS (Q0) dont l'électrode de grille est connectée au second noeud, et le transistor MOS et le transistor MOS supplémentaire (Q0, Q1) ont le même type de conductivité.

7. Le circuit de l'une quelconque des revendications 4 à 6, dans lequel la structure à miroirs de courant comprend un ensemble de miroirs de courant.

8. Le circuit de l'une quelconque des revendications précédentes, dans lequel des moyens de sortie comprenant des moyens inverseurs (Q5 à Q8) sont connectés au noeud précité (C) entre les premier et second transistors MOS complémentaires (Q3, Q4).

9. Le circuit de la revendication 8, dans lequel les moyens inverseurs sont formés par deux inverseurs CMOS (Q5, Q6 et Q7, Q8).

10. Le circuit de l'une quelconque des revendications précédentes, dans lequel des moyens supplémentaires (Q9, Q10) sont incorporés et réagissent au changement de potentiel prédéterminé sur le noeud précité (C) en réduisant la consommation de courant du circuit à la suite de l'indication précitée.

11. Le circuit de la revendication 10, dans lequel les moyens supplémentaires (Q9, Q10) comprennent des moyens qui sont destinés à faire cesser la circulation du courant dans la structure à miroirs de courant (Q1, Q2).

**Patentansprüche**

1. CMOS-Schaltung zur Erkennung einwandfreier Stromversorgung, enthaltend erste und zweite Zuführleitungen (10, 20); erste und zweite komplementäre MOS-Transistoren (Q3, Q4), die zwischen den ersten und zweiten Zuführleitungen in Reihe geschaltet sind, wobei ihre Drain-Elektroden zusammengeschaltet sind, um einen ersten Knoten (C) zu bilden, wobei die Gate-Elektrode des ersten Transistors (Q3) derart verbunden ist, daß der erste Transistor eine Ausgangsleitfähigkeit hat, die größer wird, sobald das Zuführpotential steigt; und gekennzeichnet durch kapazitive Einrichtungen (C0), in denen ein Ladestrom (I0) erzeugt wird in Reaktion auf ein steigendes Zuführpotential (VDD); Einrichtungen (Q1, Q2) zum Treiben der Gate-Elektrode des zweiten Transistors (Q4), um eine zweite Ausgangsleitfähigkeit zu erzeugen, die von dem Ladestrom (I0) abhängt, wobei eine Anzeige, daß das Zuführpotential (VDD) einen vorbestimmten Maximalwert erreicht hat, durch eine vorbestimmte Potentialsänderung an dem Knoten erzeugt wird in Abhängikeit der Relativwerte der ersten und zweiten Ausgangsleitfähigkeiten.

2. Schaltung nach Anspruch 1, wobei der Ladestrom (I0) in der kapazitiven Einrichtung (C0) durch eine erste Diodeneinrichtung (Q0) erzeugt wird, die mit der kapazitiven Einrichtung zwischen der ersten und zweiten Zufuhrleitung (10, 20) in Reihe geschaltet ist, und wobei dazwischen ein zweiter Knoten (A) gebildet wird.

3. Schaltung nach Anspruch 2, wobei die erste Diodeneinrichtung (Q0) durch einen dritten MOS-Transistor gebildet wird, dessen Gate-Elektrode mit dem zweiten Knoten verbunden ist.

4. Schaltung nach einem der vorangehenden Ansprüche, wobei die Einrichtungen zum Treiben der Gate-Elektrode des zweiten Transistors (Q4) Stromspiegeleinrichtungen (Q1, Q2) enthält, wodurch der Strom, der durch den zweiten Transistor weitergeleitet wird, ein vorbestimmtes Vielfaches des Ladestroms (I0) in der kapazitiven Einrichtung (C0) ist.

5. Schaltung nach Anspruch 4, wobei die Stromspiegeleinrichtung einen weiteren MOS-Transistor (Q1) und eine zweite Diodeneinrichtung (Q2) enthält, die zwischen der ersten und zweiten Zuführleitung (10, 20) in Reihe geschaltet sind und einen dritten Knoten (B) dazwischen haben, wobei der dritte Knoten mit der Gate-Elektrode des zweiten Transistors (Q4) verbunden ist und die Gate-Elektrode des weiteren MOS-Transistors Q1) mit dem zweiten Knoten (A) verbunden ist.

6. Schaltung nach Anspruch 5, wobei die erste Diodeneinrichtung durch einen MOS-Transistor (Q0) gebildet wird, dessen Gate-Elektrode mit dem zweiten Knoten verbunden ist, und wobei der zweite MOS und weitere MOS-Transistoren (Q0, Q1) die gleiche Art der Leitfähigkeit haben.

7. Schaltung nach einem der Ansprüche 4 bis 6, wobei die Stromspiegeleinrichtung eine Vielzahl von Stromspiegeln enthält.

8. Schaltung nach einem der vorangehenden Ansprüche, wobei eine Ausgangseinrichtung, die Invertiereinrichtungen (Q5 bis Q8) enthält, mit dem Knoten (C) zwischen dem ersten und zweiten komplementären MOS-Transistor (Q3, Q4) verbunden ist.

9. Schaltung nach Aspruch 8, wobei die Invertiereinrichtung durch zwei CMOS-Inverter (Q5, Q6 und Q7, Q8) gebildet ist.

10. Schaltung nach einem der vorangehenden Ansprüche, wobei eine Zusatzeinrichtung (Q9, Q10) vorgesehen ist, die auf die vorgegebene Potentialänderung an dem Knoten (C) reagiert zum Reduzieren des Stromverbrauchs durch die Schaltung im Anschluß an die Anzeige.

11. Schaltung nach Anspruch 10, wobei die Zusatzeinrichtung (Q9, Q10) eine Einrichtung enthält zur Beendigung des Stroms in der Stromspiegeleinrichtung (Q1, Q2) enthält.

Fig. 1

Fig. 2